# EUROPEAN PATENT SPECIFICATION

(11) **EP 2 690 192 B1**
(45) Date of publication and mention of the grant of the patent: **19.08.2015**
(21) Application number: 11862536.7
(22) Date of filing: 25.03.2011
(51) Int. Cl.: C23C 14/08, C23C 14/35, C04B 35/453

(54) **MULTI-ELEMENTS-DOPED ZINC OXIDE FILM, MANUFACTURING METHOD AND APPLICATION THEREOF**
MIT MEHREREN ELEMENTEN DOTIERTE ZINKOXIDSCHICHT, HERSTELLUNGSVERFAHREN UND ANWENDUNG
FILM D'OXYDE DE ZINC DOPÉ PAR DE MULTIPLES ÉLÉMENTS, PROCÉDÉ DE FABRICATION ET APPLICATION ASSOCIÉE

(43) Date of publication of application: 29.01.2014
(73) Proprietor: Ocean's King Lighting Science&Technology Co., Ltd., Guangdong 518054 (CN)
(72) Inventor: ZHOU, Mingjie, Shenzhen Guangdong 518054 (CN); WANG, Ping, Shenzhen Guangdong 518054 (CN); CHEN, Jixing, Shenzhen Guangdong 518054 (CN); HUANG, Hui, Shenzhen Guangdong 518054 (CN)
(74) Representative: MERH-IP Matias Erny Reichl Hoffmann
(86) International application number: PCT/CN2011/072144
(87) International publication number: WO 2012/129757

(56) References cited:
- WO-A1-2009/078329
- CN-A- 101 189 358
- CN-A- 101 208 453
- JP-A- 6 032 617
- KR-A- 20090 043 774
- US-A1- 2009 197 757

## Description

### TECHNICAL FIELD

This invention relates to the technical field of manufacture of semiconductor opto-electronic material, particularly, to a preparation method of a multi-elements doped zinc oxide film and the film made thereby and the application of the film.

### BACKGROUND

In recent years, the research on transparent conductive film with flexible substrate has been conducted all over the world, because the transparent conductive film with flexible substrate has a promising prospect of application, it has not only the characteristics of transparent conductive film with glass substrate, but also many unique advantages, such as flexibility, light weight, impact resistance, easy to produce in large area, easy to transport and the like, therefore it has broad application prospects in the field of flexible light-emitting devices, plastic liquid crystal displays and solar cells with plastic substrates and the like.

Currently the majority of the available transparent conductive films are made of the stannum doped indium oxide (Sn-doped In₂O₃, ITO film for short).Although the ITO film is a transparent conductive film with excellent universal photoelectric properties, and broadest application, the indium has the problems of toxic, expensive, poor stability, and the probability of device performance degradation caused by the indium diffusion, thus the researchers are trying to find an replacement material for ITO with the advantages of inexpensive and excellent performance. The doped zinc oxide system is a hot spot at home and abroad, as the zinc oxide is inexpensive and non-toxic, which may have good electrical and optical properties comparable to ITO after being doped with aluminum, gallium, indium, fluorine and silicon, thus it has become the most competitive transparent conductive film material. However, for a single-element doped zinc oxide film, it is not easy to prepare a film with low resistance in production, and the obtained film has poor conductivity and chemical stability.For example, the gallium doped zinc oxide film has the problems of degraded electronic performance caused by the oxygen absorption on the surfaces and grain boundaries, and the stability of the aluminum doped zinc oxide is not good enough because of the trend of overflow from surface for the oxygen atoms, and so on.

CN 1012088453 A shows sputtering method for forming transparent conductive films using a sintered sputtering target based on gallium oxide and zinc oxide and additionally containing 20-500 mass ppm of aluminium oxide.

The transparent conductive film made by magnetron sputtering has the advantages of high deposition rate, good film adhesion, easy to control and can realize large area deposition and thus this method has become one of the most studied, the most mature in process and the most widely used processes in industrialized production nowadays.But only the polycrystalline film with poor crystallization quality can be usually prepared on the ordinary domestic magnetron sputtering equipments, and the crystallization quality can be improved by heating the substrate or post high temperature annealing, and the resistivity may be lowered thereby.To prepare a film on an organic flexible substrates, the deposition temperature should not be too high, otherwise severe deformation of the substrate will take place.

### SUMMARY

A technical problem solved by the present invention is to overcome the shortcomings of prior art, and provide a method for manufacturing a multi-elements doped zinc oxide film and the film made thereby and the application of the film.

Another object of the present invention is to provide a multi-elements doped zinc oxide film made by the above-said method for manufacturing a multi-elements doped zinc oxide film.

Another yet object of the present invention is to provide the application of the above-said multi-elements doped zinc oxide film in the semiconductor opto-electronic elements.

The above-mentioned technical problems can be solved through the following technical solutions: a method for manufacturing a multi-elements doped zinc oxide film and the film made thereby and the application of the film are provided at first aspect, which method comprises following steps:

mixing Ga₂O₃ powder, Al₂O₃ powder, SiO₂ powder, and ZnO powder, sintering the resulted mixture to give a target, wherein the Ga₂O₃ powder accounts for 0.5%-10% of the total weight, the Al₂O₃ powder accounts for 0.5%-5% of the total weight, the SiO₂ powder accounts for 0.5%-1.5% of the total weight, and the rest is ZnO powder;

loading the target into a magnetron sputtering chamber, then evacuating the chamber, and setting the operating pressure within the range of 0.2 Pa to 5 Pa, then inletting a mixed gas of an inert gas and a hydrogen gas into the chamber at a flow rate of 15sccm to 25sccm, and sputtering on a substrate to give a multi-elements doped zinc oxide film, wherein the power of the sputtering is in the range of 40W to 200W.

The embodiments of the present invention provide a preparation method of a multi-element target, which employs magnetron sputtering, and a multi-elements doped zinc oxide film is obtained by sputtering, which method has the advantages of high deposition rate, good film adhesion, easy to control and can realize large area deposition. Furthermore, the means of being multi-element doped may have the effect of low resistance, and improved photoelectric properties. Furthermore, a mixture of an inert gas and a hydrogen gas is used as the working gas in the sputtering chamber, which enables a doped zinc oxide film with lower resistance be obtained at a lower temperature.

### BRIEF DESCRIPTION OF THE DRAWINGS

FIG. 1 is a flow chart of a preparation method of the multi-elements doped zinc oxide film according to the embodiments of the present invention.
FIG. 2 is a transmission spectrum of the multi-elements doped zinc oxide film according to Example 1 of the present invention in the UV-visible region.
FIG. 3 is a resistance curve of the multi-elements doped zinc oxide film made in Example 1 of the present invention when employed for 48 hours at different temperatures.

### DETAILED DESCRIPTION OF THE PREFERRED EMBODIMENTS

Objects, advantages and embodiments of the present invention will be explained below in detail with reference to the drawings and the embodiments. However, it is to be appreciated that the following description of the embodiments is merely exemplary in nature and is no way intended to limit the invention.

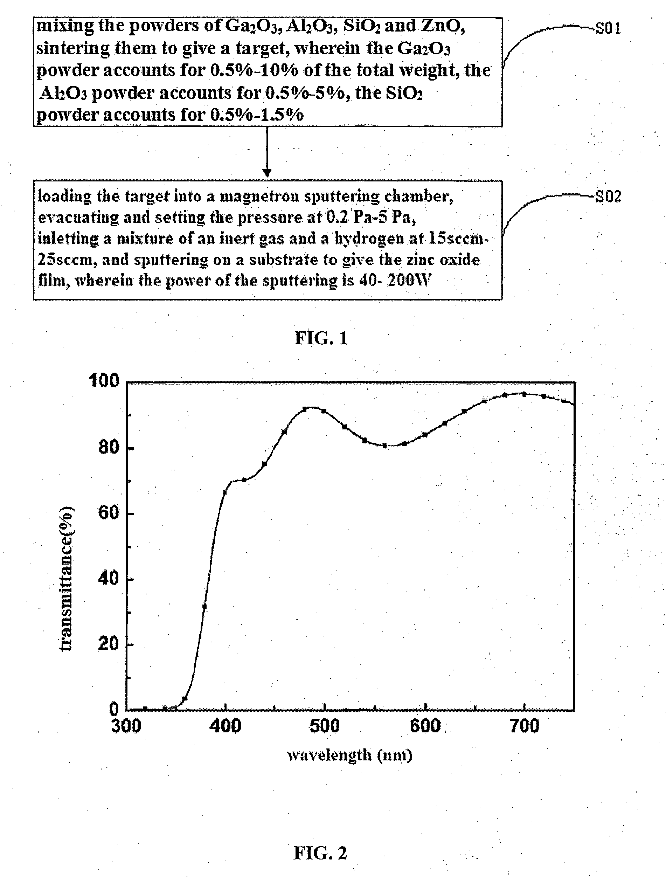

Referring to FIG 1, a method for manufacturing the multi-elements doped zinc oxide film according to the embodiments of the present invention is shown, which comprises:

S01: mixing Ga₂O₃ powder, Al₂O₃ powder, SiO₂ powder, and ZnO powder, sintering the resulted mixture to give a target, wherein the Ga₂O₃ powder accounts for 0.5%-10% of the total weight, the Al₂O₃ powder accounts for 0.5%-5% of the total weight, the SiO₂ powder accounts for 0.5%-1.5% of the total weight;

S02: loading the target into a magnetron sputtering chamber, then evacuating the chamber, and setting the operating pressure within the range of 0.2 Pa to 5 Pa, then inletting a mixed gas of an inert gas and a hydrogen gas into the chamber at a flow rate of 15sccm to 25sccm, and sputtering on a substrate to give a multi-elements doped zinc oxide film, wherein the power of the sputtering is in the range of 40W to 200W.

In the step S01, the Ga₂O₃ powder, Al₂O₃ powder, SiO₂ powder and ZnO powder are mixed uniformly, wherein the ZnO is used as substrate. The said mixed powders are sintered at the temperature of 900°C-1300°C to obtain a sputtering target material. Preferably, the Ga₂O₃ powder accounts for 2% to 4% of the total weight, the Al₂O₃ powder accounts for 0.8% to 1.5% of the total weight, the SiO₂ powder accounts for 0.6% to 1% of the total weight. The aluminum and gallium may improve the conductivity of the zinc oxide, and the silicon may have the function of stabilizing the conductivity and chemical properties, and the doped gallium may increase the bandwidth of the film, and expand the wavelength range of transmitted light. In step S02, the process of sputtering to give a multi-elements doped zinc oxide film may be carried out by selecting a quartz substrate or an organic flexible substrate. The organic flexible substrate includes: polyethylene terephthalate (PET), polycarbonate (PC), polyethylene naphthalate (PEN), polyether sulfone (PES) and the like. The flexible substrate has the advantages of good flexibility, low cost, but because of its poor smoothness, low melting point, many processes for manufacturing transparent conductive films don't employ the flexible substrate. The temperature of the substrate is controlled at below 100 °C by cooling water. The substrate is ultrasonic washed in absolute alcohol and deionized water separately and blown to dry in high purity nitrogen before use. The distance between the target and the substrate is preferably in the range of 50mm to 90mm. After the target has been loaded into the sputtering chamber, the chamber is evacuated by means of a mechanical pump or a turbo pump to the vacuum degree of 1.0 × 10⁻³ Pa to 1.0 × 10⁻⁵ Pa, preferably 6.0 × 10⁻⁴ Pa . To get a multi-elements doped zinc oxide film with excellent performance, the process condition setting is very important. The working gas in the sputtering chamber is a mixture of an inert gas and a hydrogen gas, wherein the molar volume percentage of the hydrogen gas is in the range of 1% to 5%, preferably, the mole percentage of the hydrogen gas is in the range of 3% to 6%, and more preferably, the molar volume percentage of the hydrogen gas is 5%. The flow rate of the mixed gas is preferably in the range of 18 sccm to 22 sccm, and the working pressure is preferably ranged from 0.8 Pa ∼ 1.2 Pa, the sputtering power is preferably ranged from 80 W ∼ 120 W. The thickness of the film is in the range of 150 nm to 500 nm.

The embodiments of the present invention further provide a multi-elements doped zinc oxide film made by the above-said preparation method of a multi-elements doped zinc oxide film, which works at the temperature of 0°C to 120 °C, and the resistance change rate thereof is less than 15%.

And the application of the above-mentioned multi-elements doped zinc oxide film in the preparation of semiconductor opto-electronic elements is also provided, and the multi-elements doped zinc oxide film is mainly employed in the transparent heating elements, antistatic, electromagnetic wave shield films, and solar transparent electrodes.

The preparation method of multi-elements doped zinc oxide film provided in the embodiment of the present invention employs magnetron sputtering to achieve the greatest degree of reduction of the resistance of the film, furthermore, the doping endows the zinc oxide with stable conductivity and chemical properties, and increased film bandwidth, meanwhile a high transmission in the visible region is ensured. Moreover, with a mixture of an inert gas and a hydrogen gas being used as the working gas in the process of sputtering, a multi-elements doped zinc oxide film with lower resistance may be manufactured under lower temperature.

The present invention will be explained in detail referring to following Examples.

### Example 1:

Ga₂O₃ powder, Al₂O₃ powder, SiO₂ powder and ZnO powder were mixed uniformly, wherein the Ga₂O₃ powder accounted for 1.5% of the total weight, the Al₂O₃ powder accounted for 2% of the total weight, the SiO₂ powder accounted for 1% of the total weight; the ZnO powder accounted for 95.5% of the total weight, after mixed uniformly, the resulted mixture was sintered at 1250°C to give a ceramic target of Φ 50×x2 mm, then the target was loaded into a vacuum chamber. Then a PET substrate was ultrasonic washed in absolute ethanol and deionized water sequentially, and blown to dry with high purity nitrogen, then put into the vacuum chamber. The distance between the target and the substrate was set to be 60 mm. The chamber was evacuated by a mechanical pump and a turbo pump to the vacuum degree of 6.0 × 10⁻⁴ Pa, then a mixture gas of an argon gas and a hydrogen gas was inlet into the evacuated chamber, wherein the content of the hydrogen gas was 3%(molar volume ratio), and the flow rate of the mixture gas was 20 sccm, the pressure was adjusted to 1.0Pa. The deposition of the film was initiated at a sputtering power of 100W. The multi-elements doped zinc oxide film obtained by sputtering has an average transmission in visible region of greater than 85%, and a resistivity of 9.3 × 10⁻⁴ Ω • cm.

### Example 2:

Ga₂O₃ powder, Al₂O₃ powder, SiO₂ powder and ZnO powder were mixed together uniformly, wherein the Ga₂O₃ powder accounted for 2.5% of the total weight, the Al₂O₃ powder accounted for 2% of the total weight, the SiO₂ powder accounted for 1% of the total weight; the ZnO powder accounted for 94.5% of the total weight, after mixed uniformly, the resulted mixture was sintered at 1250°C to give a ceramic target of Φ 50×2 mm, then the target was loaded into a vacuum chamber. Then a PET substrate was ultrasonic washed in absolute ethanol and deionized water sequentially, and blown to dry with high purity nitrogen, then put into the vacuum chamber. The distance between the target and the substrate was set to be 60 mm. The chamber was evacuated by a mechanical pump and a turbo pump to the vacuum degree of 6.0 × 10⁻⁴ Pa, then a mixture gas of an argon gas and a hydrogen gas was inlet into the evacuated chamber, wherein the content of the hydrogen gas was 5% (molar volume ratio), and the flow rate of the mixture gas was 20 sccm, the pressure was adjusted to 3.0Pa. The deposition of the film was initiated at a sputtering power of 120W. The multi-elements doped zinc oxide film obtained by sputtering has an average transmission in visible region of greater than 78%, and a resistivity of 8 × 10⁻⁴ Ω • cm.

### Example 3:

Ga₂O₃ powder, Al₂O₃ powder, SiO₂ powder and ZnO powder were mixed uniformly, wherein the Ga₂O₃ powder accounted for 2% of the total weight, the Al₂O₃ powder accounted for 2% of the total weight, the SiO₂ powder accounted for 1% of the total weight; the ZnO powder accounted for 95% of the total weight, after mixed uniformly, the resulted mixture was sintered at 1250°C to give a ceramic target of Φ 50×2 mm, then the target was loaded into a vacuum chamber. Then a PET substrate was ultrasonic washed in absolute ethanol and deionized water sequentially, and blown to dry with high purity nitrogen, then put into the vacuum chamber. The distance between the target and the substrate was set to be 60 mm. The chamber was evacuated with a mechanical pump and a turbo pump to the vacuum degree of 6.0 × 10⁻⁴ Pa, then a mixture gas of an argon gas and a hydrogen gas was introduced into the evacuated chamber, wherein the content of the hydrogen was 2%(molar volume ratio), and the flow rate of the mixed gas was 20 sccm, the pressure was adjusted to 2.0Pa. The deposition of the film was initiated at a sputtering power of 100W. The multi-elements doped zinc oxide film obtained by sputtering has an average transmission in visible region greater than 80%, and a resistivity of 9.9 × 10⁻⁴ Ω • cm.

### Example 4:

Ga₂O₃ powder, Al₂O₃ powder, SiO₂ powder and ZnO powder were mixed uniformly, wherein the Ga₂O₃ powder accounted for 5% of the total weight, the Al₂O₃ powder accounted for 2% of the total weight, the SiO₂ powder accounted for 1% of the total weight; the ZnO powder accounted for 92% of the total weight, after mixed uniformly, the resulted mixture was sintered at 1250°C to give a ceramic target of C 50×2 mm, then the target was loaded into a vacuum chamber. Then a PET substrate was ultrasonic washed in absolute ethanol and deionized water sequentially, and blown to dry with high purity nitrogen, then put into the vacuum chamber. The distance between the target and the substrate was set to be 60 mm. The chamber was evacuated with a mechanical pump and a turbo pump to the vacuum degree of 6.0 × 10⁻⁴ Pa, then a mixture of an argon and a hydrogen gas was inlet into the evacuated chamber, wherein the content of the hydrogen was 1 %(molar volume ratio), and the flow rate of the mixed gas was 20 sccm, the pressure was adjusted to 5.0 Pa. The deposition of the film was initiated at a sputtering power of 90W. The multi-elements doped zinc oxide film obtained by sputtering has an average transmission in visible region of greater than 88%, and a resistivity of 2.5 × 10⁻³ Ω • cm.

### Example 5:

Ga₂O₃ powder, Al₂O₃ powder, SiO₂ powder and ZnO powder were mixed uniformly, wherein the Ga₂O₃ powder accounted for 10% of the total weight, the Al₂O₃ powder accounted for 2% of the total weight, the SiO₂ powder accounted for 1% of the total weight; the ZnO powder accounted for 87% of the total weight, after mixed uniformly, the resulted mixture was sintered at 1250°C to give a ceramic target of Φ 50×2 mm, then the target was loaded into a vacuum chamber. Then a PET substrate was ultrasonic washed in absolute ethanol and deionized water sequentially, and blown to dry with high purity nitrogen, and put into the vacuum chamber. The distance between the target and the substrate was set to be 60 mm. The chamber was evacuated with a mechanical pump and a turbo pump to the vacuum degree of 6.0 × 10⁻⁴ Pa, then a mixture gas of an argon and a hydrogen was inlet into the evacuated chamber, wherein the content of the hydrogen was 2.5%(molar volume ratio), and the flow rate of the mixed gas was 20 sccm, the pressure was adjusted to 0.5 Pa. The deposition of the film was initiated at a sputtering power of 80W. The multi-elements doped zinc oxide film obtained by sputtering has an average transmission in visible region of greater than 82%, and a resistivity of 3.3 × 10⁻³ Ω • cm.

### Example 6:

Ga₂O₃ powder, Al₂O₃ powder, SiO₂ powder and ZnO powder were mixed uniformly, wherein the Ga₂O₃ powder accounted for 0.5% of the total weight, the Al₂O₃ powder accounted for 0.5% of the total weight, the SiO₂ powder accounted for 0.5% of the total weight; the ZnO powder accounted for 98.5% of the total weight, after mixed uniformly, the resulted mixture was sintered at 900°C to give a ceramic target of Φ 50×2 mm, then the target was loaded into a vacuum chamber. Then a PET substrate was ultrasonic washed in absolute ethanol and deionized water sequentially, and blown to dry with high purity nitrogen, then put into the vacuum chamber. The distance between the target and the substrate was set to be 70 mm. The chamber was evacuated with a mechanical pump and a turbo pump to the vacuum degree of 6.0 × 10⁻⁴ Pa, then a mixture gas of an argon and a hydrogen was inlet into the evacuated chamber, wherein the content of the hydrogen was 8%(molar volume ratio), and the flow rate of the mixture gas was 15 sccm, the pressure was adjusted to 1.0Pa. The deposition of the film was initiated at a sputtering power of 40W. The multi-elements doped zinc oxide film obtained by sputtering has an average transmittance in visible region of greater than 72%, and a resistivity of 9.2 × 10⁻³ Ω • cm.

### Example 7:

Ga₂O₃ powder, Al₂O₃ powder, SiO₂ powder and ZnO powder were mixed uniformly, wherein the Ga₂O₃ powder accounted for 0.5% of the total weight, the Al₂O₃ powder accounted for 5% of the total weight, the SiO₂ powder accounted for 1.5% of the total weight; the ZnO powder accounted for 93% of the total weight, after mixed uniformly, the resulted mixture was sintered at 1300°C to give a ceramic target of Φ 60×2 mm, then the target was loaded into a vacuum chamber. Then a PC substrate was ultrasonic washed in absolute ethanol and deionized water sequentially, and blown to dry with high purity nitrogen, then put into the vacuum chamber. The distance between the target and the substrate was set to be 90mm. The chamber was evacuated with a mechanical pump and a turbo pump to the vacuum degree of 6.0 × 10⁻⁴ Pa, then a mixture of an argon and a hydrogen was inlet into the evacuated chamber, wherein the content of the hydrogen was 10%(molar volume ratio), and the flow rate of the mixed gas was 15 sccm, the pressure was adjusted to 1.0 Pa. The deposition of the film was initiated at a sputtering power of 200W. The multi-elements doped zinc oxide film obtained by sputtering has an average transmission in visible region of greater than 70%, and a resistivity of 8.2 × 10⁻³ Ω • cm.

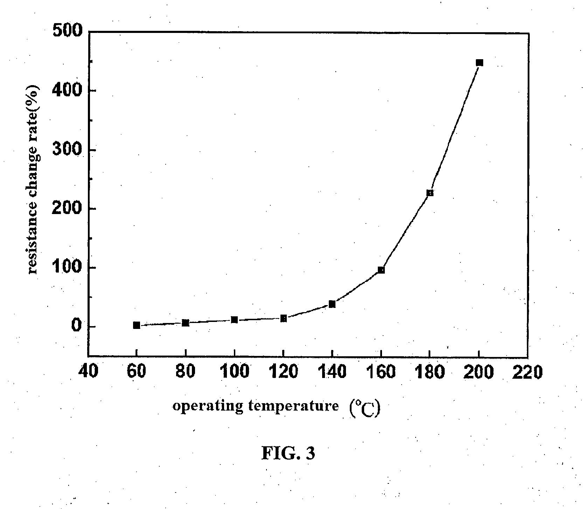

FIG. 2 shows a transmission spectrum of the multi-elements doped zinc oxide film containing a substrate of PET made in Example 1 of the present invention in the UV-visible wavelength region, which shows that the visible region transmission of the film is greater than 85%. FIG. 3 shows the resistance curve of the multi-elements doped zinc oxide film prepared in Example 1 employed at different temperatures for 48 hours. The resistance change rate is obtained by following steps: the multi-elements doped zinc oxide film is heated at the shown temperatures for 48 hours, then the new sheet resistance R₁ thereof is obtained by the detection of four probes, and the difference of this resistance value and the original resistance value Ro is divided by the original resistor Ro to give the resistance change rate; i.e., the resistance change rate R% = (R₁-R₀) / R₀. As shown in the Figure, when used at 120°C for 48 hours the resistance change rate is less than 15%, which meets with the performance standard of industrial production.

The embodiments above are merely the preferable embodiments of the present invention and not intended to limit the present invention. And all changes, equivalent substitution and improvements which come within the meaning and range of equivalency of the present invention are intended to be embraced therein.

## Claims

1. A method for manufacturing a multi-elements doped zinc oxide film, comprising following steps:
mixing Ga₂O₃ powder, Al₂O₃ powder, SiO₂ powder, and ZnO powder, sintering the resulted mixture to give a target, wherein the said Ga₂O₃ powder accounts for 0.5%-10% of the total weight, the said Al₂O₃ powder accounts for 0.5%-5% of the total weight, the said SiO₂ powder accounts for 0.5%-1.5% of the total weight, and the rest is ZnO powder;
loading the said target into a magnetron sputtering chamber, then evacuating the said chamber, and setting the operating pressure within the range of 0.2 Pa to 5 Pa, then inletting a mixed gas of an inert gas and a hydrogen gas into the said chamber at a flow rate of 15sccm to 25sccm, and sputtering on a substrate to give a multi-elements doped zinc oxide film, wherein the power of the said sputtering is in the range of 40W to 200W.

2. The method for manufacturing a multi-elements doped zinc oxide film of claim 1, wherein the said Ga₂O₃ powder accounts for 2%-4% of the total weight, the said Al₂O₃ powder accounts for 0.8%-1.5% of the total weight, the said SiO₂ powder accounts for 0.6%-1% of the total weight, the rest is ZnO powder.

3. The method for manufacturing a multi-elements doped zinc oxide film of claim 1, wherein the flow rate of the said mixed gas is preferably ranged from 18 sccm to 22 sccm, and the working pressure of the said chamber is ranged from 0.8 Pa to 1.2 Pa.

4. The method for manufacturing a multi-elements doped zinc oxide film of claim 1, wherein the molar volume percentage of the hydrogen gas in the said mixed gas is ranged from 1% to 10%.

5. The method for manufacturing a multi-elements doped zinc oxide film of claim 1, wherein the molar volume percentage of the hydrogen in the said mixed gas is ranged from 3% to 6%.

6. The method for manufacturing a multi-elements doped zinc oxide film of claim 1, wherein the said substrate is an organic flexible substrate.

7. The method for manufacturing a multi-elements doped zinc oxide film of claim 1, wherein the temperature of the said substrate is controlled to be in the range of 0°C to 100°C.

8. A multi-elements doped zinc oxide film, which is made by the method for manufacturing a multi-elements doped zinc oxide film of any of claims 1-7.

9. The multi-elements doped zinc oxide film of claim 8, wherein the resistance change rate of the said multi-elements doped zinc oxide film is less than 15% when used at the temperature of 0°C to 120 °C for 48 hours.

10. The application of the multi-elements doped zinc oxide film of claim 8 or 9 in the semiconductor opto-electronic elements.

## Patentansprüche

1. Verfahren zum Herstellen eines mit mehreren Elementen dotierten Zinkoxidfilms, wobei das Verfahren die folgenden Schritte umfasst:
Mischen von Ga₂O₃-Pulver, Al₂O₃-Pulver, SiO₂-Pulver und ZnO-Pulver, Sintern des resultierenden Gemischs, damit es ein Target ergibt, wobei das Ga₂O₃-Pulver im Bereich von 0,5 % - 10 % des Gesamtgewichts liegt, das Al₂O₃-Pulver im Bereich von 0,5 % - 5 % des Gesamtgewichts liegt, das SiO₂-Pulver im Bereich von 0,5 % - 1,5 % des Gesamtgewichts liegt und der Rest ZnO-Pulver ist;
Beschicken des Targets in eine Magnetronzerstäubungskammer, daraufhin Entleeren der Kammer und Einstellen des Betriebsdrucks innerhalb des Bereichs von 0,2 Pa bis 5 Pa, daraufhin Einlassen eines Mischgases eines Inertgases und eines Wasserstoffgases in die Kammer mit einem Durchfluss von 15 Standard-Kubikzentimetern pro Minute bis 25 Standard-Kubikzentimetern pro Minute und Zerstäuben auf ein Substrat, um einen mit mehreren Elementen dotierten Zinkoxidfilm zu ergeben, wobei die Leistung des Zerstäubens im Bereich von 40 W bis 200 W liegt.

2. Verfahren zum Herstellen eines mit mehreren Elementen dotierten Zinkoxidfilm nach Anspruch 1, wobei das Ga₂O₃-Pulver im Bereich von 2 % - 4 % des Gesamtgewichts liegt, das Al₂O₃-Pulver im Bereich von 0,8 % - 1,5 % des Gesamtgewichts liegt, das SiO₂-Pulver im Bereich von 0,6 % - 1 % des Gesamtgewichts liegt und der Rest ZnO-Pulver ist.

3. Verfahren zum Herstellen eines mit mehreren Elementen dotierten Zinkoxidfilms nach Anspruch 1, wobei der Durchfluss des Misch-gases vorzugsweise im Bereich von 18 Standard-Kubikzentimetern pro Minute bis 22 Standard-Kubikzentimetern pro Minute liegt und der Arbeitsdruck der Kammer im Bereich von 0,8 Pa bis 1,2 Pa liegt.

4. Verfahren zum Herstellen eines mit mehreren Elementen dotierten Zinkoxidfilms nach Anspruch 1, wobei der Molvolumenprozentsatz des Wasserstoffgases in dem Mischgas im Bereich von 1 % bis 10 % liegt.

5. Verfahren zum Herstellen eines mit mehreren Elementen dotierten Zinkoxidfilms nach Anspruch 1, wobei der Molvolumenprozentsatz des Wasserstoffs in dem Mischgas im Bereich von 3 % bis 6 % liegt.

6. Verfahren zum Herstellen eines mit mehreren Elementen dotierten Zinkoxidfilms nach Anspruch 1, wobei das Substrat ein organisches biegsames Substrat ist.

7. Verfahren zum Herstellen eines mit mehreren Elementen dotierten Zinkoxidfilms nach Anspruch 1, wobei die Temperatur des Substrats in der Weise gesteuert wird, dass sie im Bereich von 0 °C bis 100 °C liegt.

8. Mit mehreren Elementen dotierter Zinkoxidfilm, der durch das Verfahren zum Herstellen eines mit mehreren Elementen dotierten Zinkoxidfilms nach einem der Ansprüche 1-7 hergestellt worden ist.

9. Mit mehreren Elementen dotierter Zinkoxidfilm nach Anspruch 8, wobei die Widerstandsänderungsrate des mit mehreren Elementen dotierten Zinkoxidfilms, wenn er 48 Stunden bei der Temperatur von 0 °C bis 120 °C verwendet wird, kleiner als 15 % ist.

10. Anwendung des mit mehreren Elementen dotierten Zinkoxidfilms nach Anspruch 8 oder 9 in den Halbleiter-Optoelektronikelementen.

## Revendications

1. Procédé pour fabriquer un film d'oxyde de zinc dopé avec des éléments multiples, comprenant les étapes suivantes :
on mélange de la poudre de Ga₂O₃, de la poudre de Al₂O₃, de la poudre de SiO₂, et de la poudre de ZnO, on fritte le mélange résultant pour donner une cible, dans lequel ladite poudre de Ga₂O₃ représente 0,5 % à 10 % du poids total, ladite poudre de Al₂O₃ représente 0,5 % à 5 % du poids total, ladite poudre de SiO₂ représente 0,5 % à 1,5 % du poids total, et le reste est de la poudre de ZnO ;
on charge ladite cible dans une chambre de pulvérisation à magnétron, on évacue ensuite ladite chambre, et on fixe la pression de fonctionnement dans la plage de 0,2 Pa à 5Pa, puis on laisse entrer un mélange gazeux formé d'un gaz inerte et d'hydrogène gazeux dans ladite chambre à un débit de 15 cm³/s à 25 cm³/s, et on procède à une pulvérisation sur un substrat pour donner un film d'oxyde de zinc dopé avec des éléments multiples, dans lequel la puissance de ladite pulvérisation est dans la plage de 40 W à 200 W.

2. Procédé pour fabriquer un film d'oxyde de zinc dopé avec des éléments multiples selon la revendication 1, dans lequel ladite poudre de Ga₂O₃ représente 2 % à 4 % du poids total, ladite poudre de Al₂O₃ représente 0,8 % à 1,5 % du poids total, ladite poudre de SiO₂ représente 0,6 % à 1 % du poids total, et le reste est de la poudre de ZnO.

3. Procédé pour fabriquer un film d'oxyde de zinc dopé avec des éléments multiples selon la revendication 1, dans lequel le débit dudit mélange gazeux est de préférence dans la plage de 18 cm³/s à 22 cm³/s, et la pression de travail dans ladite chambre est dans la plage de 0,8 Pa à 1,2 Pa.

4. Procédé pour fabriquer un film d'oxyde de zinc dopé avec des éléments multiples selon la revendication 1, dans lequel le pourcentage du volume molaire de l'hydrogène gazeux dans ledit mélange gazeux est dans la plage de 1 % à 10 %.

5. Procédé pour fabriquer un film d'oxyde de zinc dopé avec des éléments multiples selon la revendication 1, dans lequel le pourcentage du volume molaire de l'hydrogène dans ledit mélange gazeux est dans la plage de 3 % à 6 %.

6. Procédé pour fabriquer un film d'oxyde de zinc dopé avec des éléments multiples selon la revendication 1, dans lequel ledit substrat est un substrat flexible organique.

7. Procédé pour fabriquer un film d'oxyde de zinc dopé avec des éléments multiples selon la revendication 1, dans lequel on commande la température dudit substrat pour tomber dans la plage de 0°C à 100°C.

8. Film d'oxyde de zinc dopé avec des éléments multiples, qui est réalisé par le procédé pour fabriquer un film d'oxyde de zinc dopé avec des éléments multiples selon l'une quelconque des revendications 1 à 7.

9. Film d'oxyde de zinc dopé avec des éléments multiples selon la revendication 8, dans lequel le taux de changement de résistance dudit film d'oxyde de zinc dopé avec des éléments multiples est inférieur à 15 % quand on l'utilise à la température de 0°C à 120°C pendant 48 heures.

10. Application du film d'oxyde de zinc dopé avec des éléments multiples de la revendication 8 ou 9 dans des éléments optoélectroniques à semi-conducteurs.
